Europäisches Patentamt

European Patent Office

Office européen des brevets

(19)

(11) **EP 0 608 966 B1**

(12) **EUROPEAN PATENT SPECIFICATION**

(45) Date of publication and mention
of the grant of the patent:
**31.03.1999 Bulletin 1999/13**

(51) Int Cl.⁶: **H03H 5/00**, H01F 21/08

(21) Application number: **94200836.8**

(22) Date of filing: **12.12.1988**

(54) **Adjustable reactance device and method**

Einstellbare Reaktanzvorrichtung und Verfahren

Réactance variable

(84) Designated Contracting States:
**AT BE CH DE FR GB IT LI LU NL SE**

(30) Priority: **10.12.1987 AU 5855/87**

(43) Date of publication of application:
**03.08.1994 Bulletin 1994/31**

(62) Document number(s) of the earlier application(s) in
accordance with Art. 76 EPC:
**89900176.2 / 0 393 103**

(73) Proprietors:
• **THE UNIVERSITY OF WESTERN AUSTRALIA
Nedlands, Western Australia 6009 (AU)**
• **MAGELLAN TECHNOLOGY PTY. LIMITED
Canningvale, W.A. 6155 (AU)**

(72) Inventor: **Murdoch, Graham Alexander Munro
Western Australia (AU)**

(74) Representative: **Newstead, Michael John et al
Page Hargrave
Temple Gate House
Temple Gate
Bristol BS1 6PL (GB)**

(56) References cited:
**GB-A- 449 240**          **GB-A- 2 031 666**
**GB-A- 2 031 667**       **GB-A- 2 121 248**
**US-A- 3 631 534**

## Description

### FIELD OF INVENTION

The present invention relates to tunable circuits. In one form, the present invention is adapted to generate, enhance and/or control oscillating currents by virtue of reactance control.

In another form of the present invention has application in tuning circuits and/or the generation and/or control of relatively high frequency currents which circulate in a tuned coil. Another application of the present invention is in the control of electric devices, such as electric motors. The present invention, however, should not be limited to only such applications.

### BACKGROUND ART

Large oscillating currents may be usefully employed in many commercial applications where their ability to generate heat, provide motive power, be converted to different impedance levels and/or be radiated for communication purposes amongst other applications, and are thus considered extremely useful. Often oscillating currents are generated and/or controlled using tuned circuits where the inductance and capacitance are tuned to resonate at or near the oscillation frequency of the generating device.

In order to facilitate the use of large high frequency currents circulating in a tuned coil, generation and/or control of them needs to be managed. To efficiently generate high frequency currents in a coil, the coil must be tuned relatively accurately to the frequency of the currents. In this way the phenomena of resonance can be used to enhance the coils efficiency and by nulling out the coils inductive reactance.

Linear tuning methods such as varicap diodes are not usable for currents above a few milliamperes or voltages above a few volts. Where currents of amps or higher are involved tuning is currently done by switching in discrete value capacitors or using large ferrite slug tuners or variable plate capacitors where servo motors control the mechanical position of the tuning elements.

Some prior art arrangements produce sub harmonics for signalling at relatively low frequencies by the synchronous switching of a circuit element in and out of the circuit for whole cycles. This, however, has not been found to be desirable nor useful in tuning a circuit.

By controlling the tuning, it has been found possible to vary the phase of currents circulating in the resonant coil.

An example application of the present adjustable reactance being used in conjunction with a tuned coil is in the application of the antenna structure disclosed in the present Applicant's US patent No. 5258766. Where that antenna structure is used in the sorting of airline baggage, the passage of a metal brief case often causes the tuning coils of the antenna to become detuned. There is therefore a need to provide an apparatus which is adapted to readily retune such an antenna structure and specifically for the retuning of tuned coils.

A further example of the prior art is that disclosed in US 4210860 (which is equivalent to GB 2031666). This citation discloses a VAR generator, wherein below a certain current value the reactance of the generator is one value, and above the current value the reactance is another value. That is, this citation discloses a simple switch system which is capable of choosing between two predefined values. It uses a saturable reactor, such that the reactor has one predefined value when current is below a certain level, however, once the current is above that level the reactance value is switched to a second predefined value.

### SUMMARY OF INVENTION.

To this end, the present invention provides a reactance of predetermined or variable value in circuit by truncating voltage across or current in the reactance. Any one of a number of reactance values in a tuning element can be attained which are suitable for relatively high current/voltage tuned circuits. Duty cycle control of the truncating is preferred. Truncation within at least one portion of a signal cycle is also preferred. Synchronous truncation is a further preferred feature. The truncation may still further be provided each cycle or every second cycle every third cycle, etc.

The present invention therefore provides a high current/voltage tunable circuit comprising:

a first reactance device ;
a second reactance device ; and
a truncation means coupled to said second reactance device ;
characterised in that said truncation means is adapted to control the voltage across or current in said second reactance device ; and
a control means is connected to said truncation means to control the operation of said truncation means in response to inputs to said control means;
wherein the operation of said truncation means varies the voltage across or current in said second reactance device , thereby varying the effective reactance value of said second reactance device ;
whereby tuning is effected by the effective reactance value of said second reactance device.

Said truncation means may operate in response to a duty cycle.

The effective reactance value may be increased above or decreased below the physical value of the second reactance device.

Said truncation means may be a switch.

Said second reactance device may be a capacitor or an inductor.

The present invention is predicated on the principle that where tuned circuits have a high Q factor they will reject harmonic currents and provide a low impedance path to circulating currents at the resonant frequency. Consequently a tuning element which exhibits a non-linear VI characteristic can function as an effective tuning element where the apparent reactance is given by the fundamental component of the VI characteristic. Harmonic components being rejected by the high Q of the resonant circuit.

Capacitors and inductors normally exhibit linear VI characteristics and have sinusoidal voltage and current curves when excited by sinusoidal currents and voltage. Importantly, if segment(s) of the voltage curves over each cycle are truncated to zero volts, or reduced, the inductor or capacitor will still exhibit an effective inductance or capacitance which will depend upon the fundamental voltage component across the inductor or capacitor.

If $V_F$ is the fundamental voltage component across the inductor/capacitor then the effective inductance $L_C$ or capacitance $C_C$ is given by

$$C_C = \frac{V_O}{V_F} \cdot C \qquad L_C = \frac{V_F}{V_O} \cdot L$$

where $V_O$ is the fundamental voltage across the unmodified inductance L or capacitor C.

As a greater and greater portion of the inductors or capacitors voltage over each cycle is truncated to zero volts, or is reduced, the effective inductance Le changes in value from L to zero whereas; the effective capacitance changes in value from C to infinity. Truncation may be effected by dc control or switching. The truncation may also be effected synchronously. Defining the duty cycle as the ratio of truncated to undisturbed voltage then control of the duty cycle provides a means of linear control of inductance or capacitance. High efficiency operation at high voltages and currents is possible using low resistance semiconductor switches such as MOSFETS. These sort of devices are ideally suited to the application and need only operate as a high speed switch.

Alternatively the sharp onset of saturation in a magnetic core can be used to provide the truncation of inductor voltage to zero. A voltage fed to the core serves to vary the onset of core saturation and therefore the level of truncation. Above saturation the dynamic impedance of an inductor is very low and the inductor voltage will be nearly zero. Below saturation the voltage across the inductance will be high because of the high core inductance. Such a method is useful where very high voltages are present and semiconductor switches are insufficiently rated. A penalty of the saturation system is the losses in the core material.

In one embodiment it should be noted that the effective reactance of an inductance or capacitance can be controlled by either synchronously shorting the element or by open circuiting the element from the circuit. The duty cycle of a parallel synchronous switch which periodically shorts the capacitor or inductor should preferentially close when the voltage is zero.

Any suitable switch means may be used to either short or open circuit the element in the circuit.

A series connected synchronous switch which periodically open circuits a capacitor or inductor from the circuit should preferentially open when the current is zero.

The parallel implementation reduces the effective reactance with the closure of the switch whereas the series implementation increases the effective reactance with the opening of the switch.

By varying the opening or closing duty cycle, the effective reactance, as "seen" by the circuit or tuned coil, of the element can be varied.

For example with reference to the parallel implementation, where a switch is provided in parallel with a capacitor, when the switch is open, current flows through the capacitor, but the current bypasses the capacitor when the switch is closed. The effective value of the capacitor can be varied where the magnitude of the fundamental component of voltage cross switch is adjusted independently of the current flowing through it. Thus, by shorting the switch periodically, the fundamental component of voltage across the capacitor appears to be lower. In this way, the effective size of the capacitor appears to be larger than it actually is.

Preferred embodiments of the present invention will now be described with reference to the accompanying drawings where :

Figures 1, 2, 3, 4, 6 and 7 show inductive embodiments.

Figures 5, 6 and 8 show reactor embodiments.

Figures 9, 10, 11 and 12 show capacitive embodiments.

In the embodiments referred to, the duty cycle is variable over one portion or any number of portions of each period (cycle).

In another form, the reactance element is switchable between relatively high or low Z states or shorted out.

To improve the current(s) within the coil(s), each coil pair is tuned to resonance or near resonance at an operating frequency. Accurate tuning of the coil(s) provides for more efficient operation. Control of the resonate frequency may be provided by using a variable inductor, saturable reactor or variable capacitor in series or parallel with each coil or coil pair.

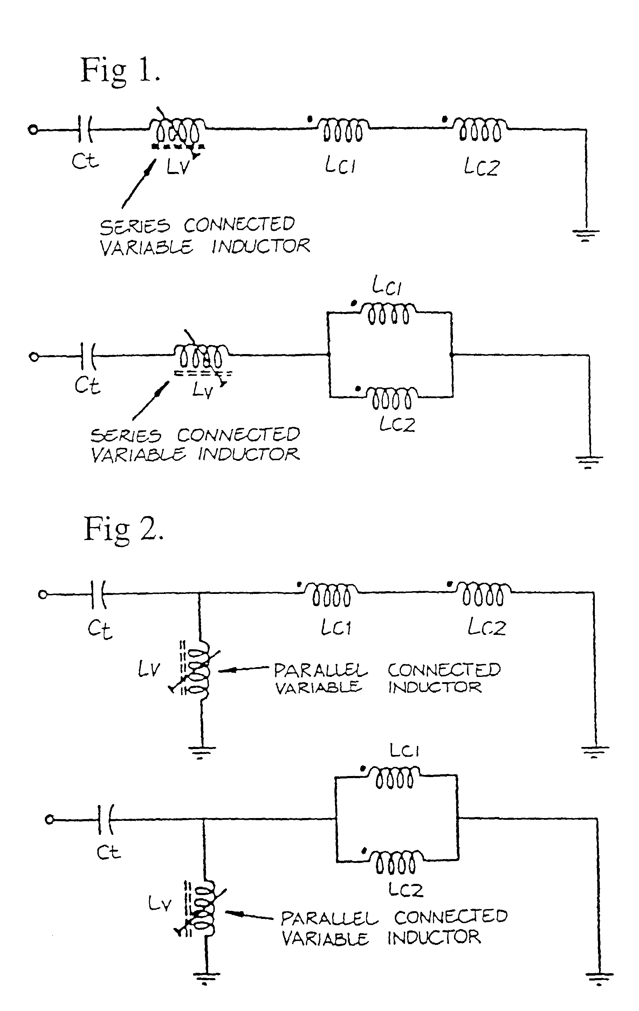

Inductance is varied by a dc current. Phase sensing circuitry may monitor the current within the coil pairs and produce a dc current for controlling the variable inductor. Control of the phase of the currents circulating in the coils may be achieved by the phase means. A signal source of required frequency and phase drives each coil pair. The variable inductor enables each coil to be tuned to resonate at substantially the same frequency. The variable inductor may also provide compensation for fluctuations in coil tuning caused by time, temperature, object proximity, etc. Figure 1 shows two series configurations and Figure 2 shows two parallel configurations incorporating a variable inductance for controlling resonant frequency.

With reference to Figures 1 and 2, $L_C1$ and $L_C2$ are the two coils used to generate the magnetic field along an axis, $C_t$ is the tuning capacitance and $L_v$ is the variable inductance. It is understood that these configurations may also apply if only one or more than two coils are used.

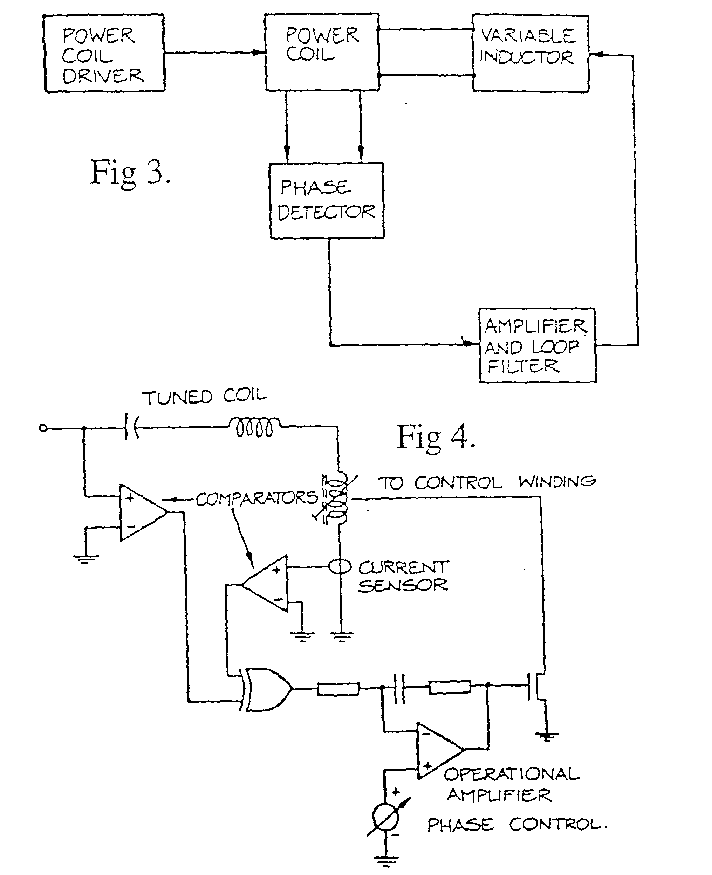

A small value resistance or current transformer coupled in series with the tuned circuit can sense the phase of the coil's current. A phase detector can compare the current's phase and the input signal's phase, the output of which can be filtered and provide a dc control current for use by the variable inductance. This system is not a phase locked loop, rather it is a phase feedback loop. Figure 3 shows a schematic of this type of system and an example circuit implementation thereof is shown in Figure 4.

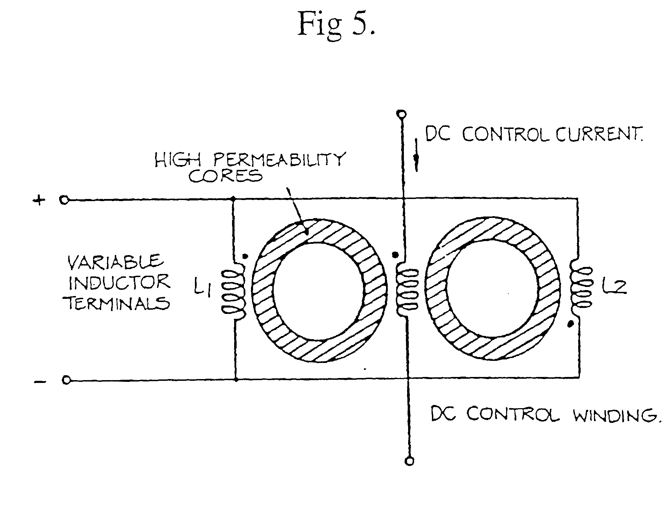

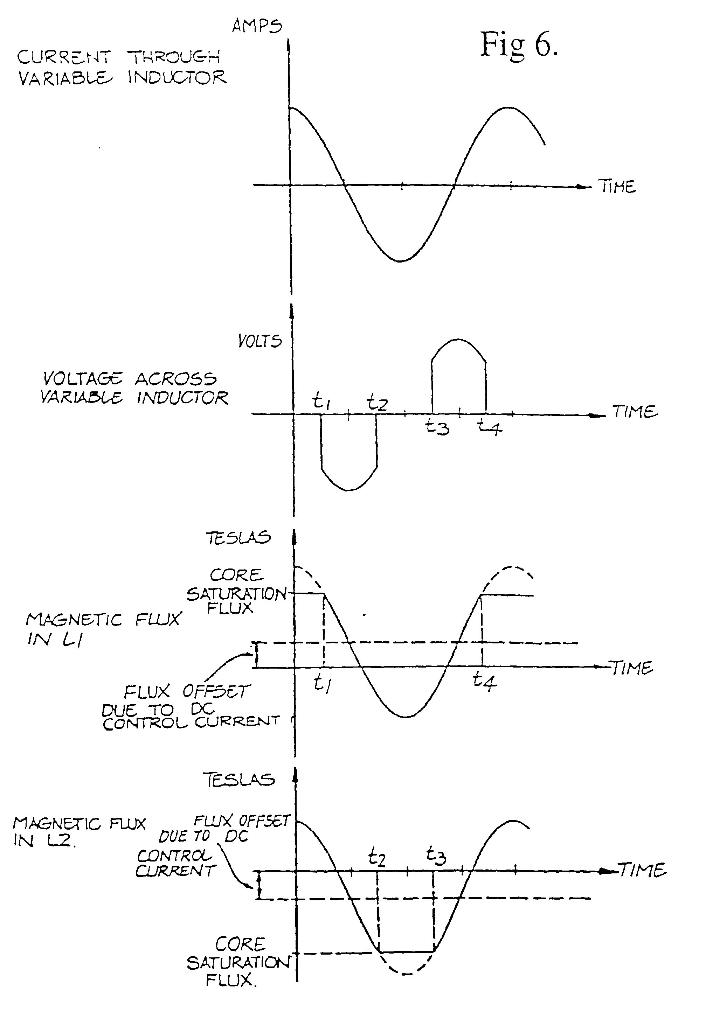

The variable inductance may preferably be made from two anti-parallel magnetically isolated coils. Figure 5 shows this in stylised form. Two high permeability cores act as magnetic paths for the flux generated by coils L1 and L2. These coils are wound so that their fluxes are oppositely directed through the control winding $L_C$. L1 and L2 have the same number of turns. Since they are wired in parallel, they both have equal voltages across them, therefore, the rate of change of flux in their respective toroid cores is substantially identical. Consequently, the total flux change in the control winding is substantially zero and little, if any, voltage is induced into the control winding, even when substantial currents flow through L1 and L2. Passing a dc current through the control winding pre-biases the cores with oppositely directed fluxes. During one half of the ac cycle, the dc flux opposes the ac flux in one core while it aids it in the other core. During the second half of the cycle, the ac flux reverses direction and aids the dc flux in the first core while opposing it in the second core. This repeats for each cycle. If the flux in the core with aiding flux exceeds the saturation level, then the dynamic permeability becomes very small and the inductance of the coil wound onto the core is reduced. The inductance of the system is substantially the parallel inductance of L1 and L2. Hence, the inductance becomes very small. While the inductance may not be constant over a cycle, the modification of the coil's resonant frequency depends upon the average inductance per cycle of the variable inductor. Various waveforms for the variable inductor are shown in Figure 6. When either L1 or L2 saturates, their inductance becomes very small and the voltage across them becomes almost zero. Inductance is defined by the voltage induced for a rate of change in current. Extracting the fundamental component of voltage across the inductor for a fixed sinusoidal current will give the effective inductance. The effect of higher harmonic terms is attenuated by the filtering action of the tuned coils. As the dc control current is increased, the effective inductance is reduced from a maximum unsaturated core value to that of parallel air cored inductors.

The preferred arrangement works well in the series connected case as shown in Figure 1. In this configuration, a small inductance with a large control range may provide adequate control of the tuned coil pair resonant frequency. Adequate control, of course, is dependent upon the overall system's particular application.

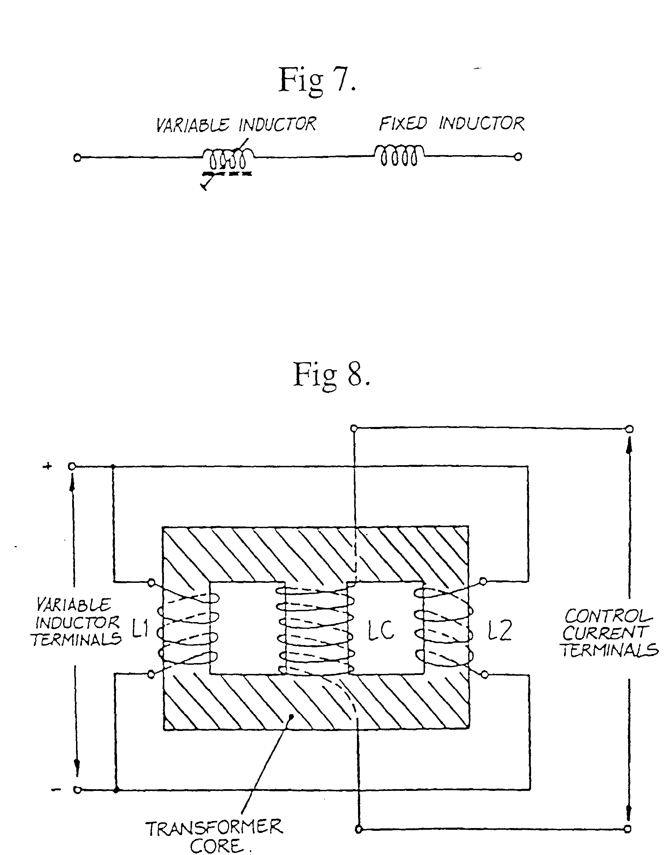

The parallel case as shown in Figure 2 may require a large parallel inductance with a small control range to adequately control the resonant frequency. This may be achieved by placing a large fixed inductance in series with a smaller variable inductance, as shown in Figure 7. A standard transformer core can also be used to construct a variable inductance, as shown in Figure 8. The rate of change of flux through the centre leg from L1 and L2 is constrained to substantially zero by the anti-parallel connection of L1 and L2. Consequently, relatively no ac voltage is coupled into the control winding $L_C$.

If ac voltage couples into the centre leg because of uneven winding of L1 and L2, then an inductance in series with the control winding will alleviate any upset in the control dc circuitry from this ac voltage.

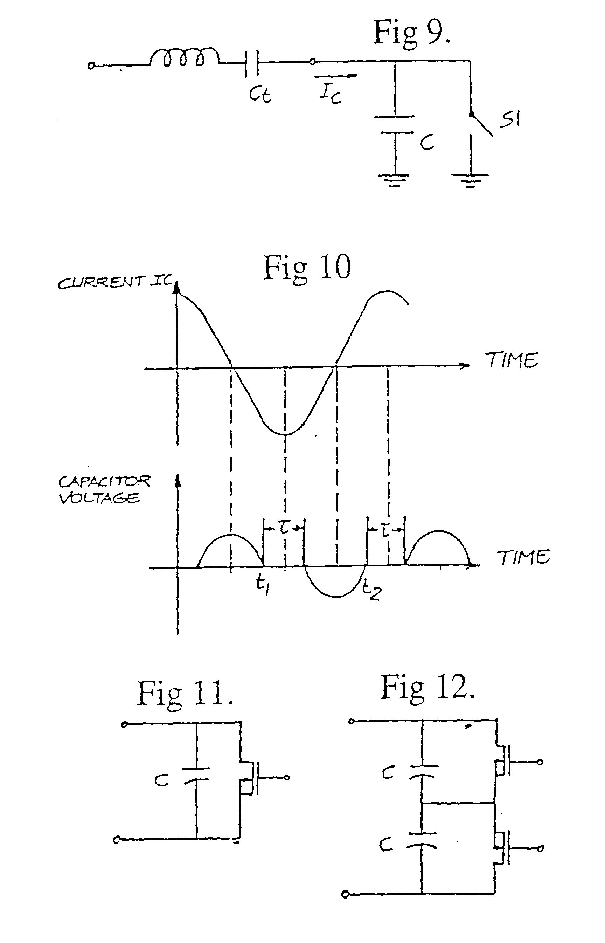

Figure 9 shows a variable capacitor used to control the coil pair resonant frequency. The capacitance is varied by controlling the duty cycle of the switch closure S1.

With reference to Figure 10, when the voltage across capacitor C in Figure 9 is zero ($t_1$) switch S1 closes and stays closed for period I where upon it opens. The capacitor C is charged for the remainder of the cycle by the coil current. When the capacitor voltage is next zero ($t_2$) the switch again recloses for I. The cycle is then repeated. The effective capacitance of the switch capacitor combination varies from the full capacitance C when the switch is always open to infinite capacitance when the switch is always closed.

Figures 11 and 12 show some practical embodiments of the variable capacitor. The dc voltage across C varies with the switching duty cycle in the circuit shown in Figure 11. The circuit shown in Figure 12 does not suffer from this.

An example application in which three tuned coils are delivering/generating magnetic fields in the three geometric directions is baggage identification tags on a conveyor system. Each coil is tuned at or near the frequency of operation.

As tags are passed through the coils they are programmed by frequency shift keying the magnetic fields. For efficient operation the coils have high Q's and are normally not amenable to FSK modulation, however if they are actively tuned using variable reactance(s) then they may be relatively instantaneously returned to the instantaneous frequency of the FSK signal.

Moreover as metal objects pass through the coils, the tuning will be changed. Thus, the resonant frequency must be adaptively altered as the coils are operated.

## Claims

1.    A high current/voltage tunable circuit comprising:

a first reactance device ;
a second reactance device (C); and
a truncation means (S1) coupled to said second reactance device (C);
characterised in that said truncation means (S1) is adapted to control the voltage across or current in said second reactance device (C); and
a control means is connected to said truncation means (S1) to control the operation of said truncation means (S1) in response to inputs to said control means;
wherein the operation of said truncation means (S1) varies the voltage across or current in said second reactance device (C), thereby varying the effective reactance value of said second reactance device (C);
whereby tuning is effected by the effective reactance value of said second reactance device (C).

2.    A circuit as claimed in claim 1, wherein said truncation means (S1) operates in response to a duty cycle.

3.    A circuit as claimed in claim 1 or 2, wherein the effective reactance value is increased above the physical value of the second reactance device (C).

4.    A circuit as claimed in claim 1 or 2, wherein the effective reactance value is decreased below the physical value of the second reactance device (C).

5.    A circuit as claimed in claim 1 or 2, wherein said truncation means (S1) is a switch (S1).

6.    A circuit as claimed in claim 1 or 2, wherein said second reactance device (C) is a capacitor (C).

7.    A circuit as claimed in claim 1 or 2, wherein said second reactance device (C) is an inductor.

8.    A method of tuning a first reactance device comprising:

applying a second reactance device (C) to said first reactance device ;
characterised in that the voltage across or current in said second reactance device (C) is truncated to thereby vary the effective reactance value of said reactance device (C);
whereby said first reactance device is tuned in response to the effective reactance value of said second reactance device (C).

9.    A method as claimed in claim 8, wherein the voltage across or current in said second reactance device is (C) is truncated during at least one portion of a signal cycle.

## Patentansprüche

1.    Abstimnbare Hochstrom/-spannungs-Schaltung, welche umfaßt:

eine erste Reaktanzeinrichtung;
eine zweite Reaktanzeinrichtung (C); und
eine an die zweite Reaktanzeinrichtung (C) gekoppelte Abbrecheinrichtung (S1);
dadurch gekennzeichnet, daß die Abbrecheinrichtung (S1) so ausgelegt ist, daß sie die Spannung über oder den Strom in der zweiten Reaktanzeinrichtung (C) steuert; und
mit der Abbrecheinrichtung (S1) eine Steuereinrichtung verbunden ist, um den Betrieb der Abbrecheinrichtung (S1) in Antwort auf Eingaben in die Steuereinrichtung zu steuern;
wobei der Betrieb der Abbrecheinrichtung (S1) die Spannung über oder den Strom in der zweiten Reaktanzeinrichtung (C) variiert, wodurch der effektive Reaktanzwert der zweiten Reaktanzeinrichtung (C) variiert wird;
wodurch ein Abstimmen durch den effektiven Reaktanzwert der zweiten Reaktanzeinrichtung (C) bewirkt wird.

2.    Schaltung nach Anspruch 1, bei der die Abbrecheinrichtung (S1) in Antwort auf einen Arbeitszyklus arbeitet.

3.    Schaltung nach Anspruch 1 oder 2, bei der der effektive Reaktanzwert über den physikalischen Wert der zweiten Reaktanzeinrichtung (C) erhöht ist.

4.    Schaltung nach Anspruch 1 oder 2, bei der der effektive Reaktanzwert unter den physikalischen Wert der zweiten Reaktanzeinrichtung (C) verringert ist.

5.    Schaltung nach Anspruch 1 oder 2, bei der die Abbrecheinrichtung (S1) ein Schalter (S1) ist.

6.    Schaltung nach Anspruch 1 oder 2, bei der die zweite Reaktanzeinrichtung (C) ein Kondensator (C) ist.

**7.** Schaltung nach Anspruch 1 oder 2, bei der die zweite Reaktanzeinrichtung (C) ein Induktor ist.

**8.** Verfahren zur Abstimmung einer ersten Reaktanzeinrichtung, welches umfaßt:

> Anbringen einer zweiten Reaktanzeinrichtung (C) an die erste Reaktanzeinrichtung; dadurch gekennzeichnet, daß die Spannung über oder der Strom in der zweiten Reaktanzeinrichtung (C) abgebrochen wird, um dadurch den effektiven Reaktanzwert der Reaktanzeinrichtung (C) zu variieren; wodurch die erste Reaktanzeinrichtung in Antwort auf den effektiven Reaktanzwert der zweiten Reaktanzeinrichtung (C) abgestimmt wird.

**9.** Verfahren nach Anspruch 8, bei dem die Spannung über oder Strom in der zweiten Reaktanzeinrichtung (C) während wenigstens eines Teils eines Signal zyklus abgebrochen wird.


## Revendications

**1.** Circuit accordable à haute tension ou courant fort qui comprend :

> un premier système à réactance ;
> un deuxième système à réactance (C); et
> un moyen de troncature (S1) couplé au deuxième système à réactance (C) ;
> caractérisé en ce que le moyen de troncature (S1) est adapté au contrôle de la tension aux bornes du deuxième système à réactance (C) ou du courant le traversant ; et que
> un moyen de contrôle est connecté au moyen de troncature (S1) pour contrôler le fonctionnement de ce moyen de troncature (S1) en réponse à des valeurs d'entrée du moyen de contrôle,
> dans lequel le fonctionnement du moyen de troncature (S1) fait varier la tension aux bornes du deuxième système à réactance (C) ou le courant le traversant, et de ce fait, fait varier la valeur effective de la réactance du deuxième système à réactance (C) ;
> l'accord étant effectué au moyen de la valeur effective de la réactance du deuxième système à réactance (C).

**2.** Circuit selon la revendication 1, dans lequel le moyen de troncature (S1) fonctionne en réponse à un cycle de marche.

**3.** Circuit selon la revendication 1 ou 2, dans lequel la valeur effective de la réactance est augmentée au-dessus de la valeur physique du deuxième système à réactance (C).

**4.** Circuit selon la revendication 1 ou 2, dans lequel la valeur effective de la réactance est diminuée au-dessous de la valeur physique du deuxième système à réactance (C).

**5.** Circuit selon la revendication 1 ou 2, dans lequel le moyen de troncature (S1) consistant en un commutateur (S1).

**6.** Circuit selon la revendication 1 ou 2, dans lequel le deuxième système à réactance (C) est un condensateur (C).

**7.** Circuit selon la revendication 1 ou 2, dans lequel le deuxième système à réactance (C) est une bobine d'inductance.

**8.** Méthode pour accorder un premier système à réactance comprenant :

> l'application d'un deuxième système à réactance (C) au premier système à réactance, caractérisée en ce que la tension aux bornes du deuxième système à réactance (C) ou le courant le traversant est tronqué pour faire varier la valeur effective de la réactance du deuxième système à réactance (C) ; le premier système à réactance étant accordé en réponse à la valeur effective de la réactance du deuxième système à réactance (C).

**9.** Méthode selon la revendication 8, dans laquelle la tension aux bornes du deuxième système à réactance (C) ou le courant le traversant est tronqué pendant au moins une partie d'un cycle de signal.

# Fig 1.

SERIES CONNECTED
VARIABLE INDUCTOR

SERIES CONNECTED
VARIABLE INDUCTOR

# Fig 2.

PARALLEL CONNECTED
VARIABLE INDUCTOR

PARALLEL CONNECTED
VARIABLE INDUCTOR

Fig 3.

POWER COIL DRIVER → POWER COIL → VARIABLE INDUCTOR

PHASE DETECTOR

AMPLIFIER AND LOOP FILTER

Fig 4.

TUNED COIL

COMPARATORS

TO CONTROL WINDING

CURRENT SENSOR

OPERATIONAL AMPLIFIER

PHASE CONTROL.

# Fig 5.

Fig 6.

CURRENT THROUGH VARIABLE INDUCTOR

VOLTAGE ACROSS VARIABLE INDUCTOR

MAGNETIC FLUX IN L1

MAGNETIC FLUX IN L2.

# Fig 7.

VARIABLE INDUCTOR

FIXED INDUCTOR

# Fig 8.

+

VARIABLE
INDUCTOR
TERMINALS

L1

LC

L2

CONTROL
CURRENT
TERMINALS

−

TRANSFORMER
CORE.

# Fig 9.

$C_t$    $\overline{I_c}$    $C$    $S1$

# Fig 10

CURRENT $I_C$

TIME

CAPACITOR VOLTAGE

$\tau$    $\tau$

$t_1$    $t_2$

TIME

# Fig 11.

$C$

# Fig 12.

$C$

$C$